# EUROPEAN PATENT SPECIFICATION

(11) **EP 1 673 859 B1**
(45) Date of publication and mention of the grant of the patent: **23.03.2011**
(21) Application number: 04795192.6
(22) Date of filing: 14.10.2004
(51) Int. Cl.: H03G 3/34, H03F 1/30, H03F 3/185

(54) **METHOD AND APPARATUS FOR RESETTING A BUFFER AMPLIFIER**
VERFAHREN UND VORRICHTUNG ZUM ZURÜCKSETZEN EINES PUFFERVERSTÄRKERS
PROCEDE ET DISPOSITIF DE REMISE A ZERO D'UN AMPLIFICATEUR-TAMPON

(30) Priority: 14.10.2003 US 510936 P; 12.10.2004 US 963130
(43) Date of publication of application: 28.06.2006
(73) Proprietor: Knowles Electronics, LLC, Itasca, Illinois 60143 (US)
(72) Inventor: BOOR, Steven, E., Plano, TX 75025 (US)
(74) Representative: Dunlop, Brian Kenneth Charles
(86) International application number: PCT/US2004/033997
(87) International publication number: WO 2005/039046

(56) References cited:
- WO-A-83/02862
- US-A- 4 754 232
- US-A- 5 255 094
- US-B1- 6 353 344
- PATENT ABSTRACTS OF JAPAN vol. 009, no. 328 (E-369), 24 December 1985 (1985-12-24) & JP 60 160711 A (MATSUSHITA DENKI SANGYO KK), 22 August 1985 (1985-08-22)

## Description

### TECHNICAL FIELD

This patent relates to a buffer amplifier and, more specifically, to a reset circuit for a buffer amplifier such as used in a miniature electret microphone.

### BACKGROUND

Hearing aids have greatly contributed to improving the quality of life for many individuals with auditory problems. Technological advancements in this field continue to improve the reception, wearing-comfort, life-span, and power efficiency of the hearing aid. With these continual advances in the performance of ear-worn acoustic devices, ever-increasing demands are placed upon improving the inherent performance of the miniature acoustic transducers that they utilize.

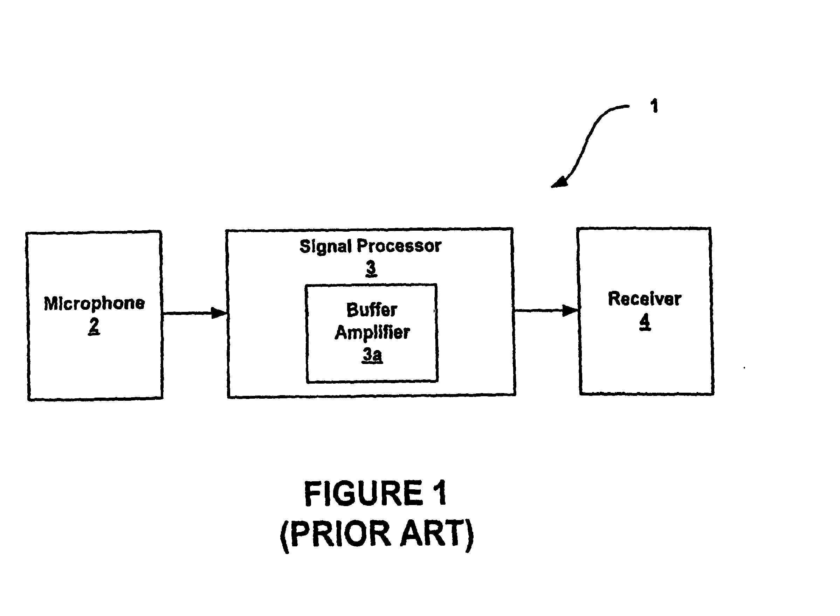

Fig. 1 shows a representative high level block diagram of a hearing aid 1. Generally speaking, the hearing aid 1 includes a microphone portion 2, a signal processing portion 3, and a receiver portion 4. The microphone portion 2 picks up sound waves in audible frequencies and creates an electronic signal representative of these sound waves. The signal processing portion 3 takes the electronic signal output from the microphone 2 and modifies the signal in manners conducive to correcting for the deficiencies of the hearing impaired user, often including amplification by buffer amplifier 3a, and then sends the processed signal to the receiver portion 4. The receiver portion 4 produces an enhanced version of the original sound waves, modified specifically to compensate for the hearing loss of the hearing impaired user.

Conventionally, the microphone portion 2 of directional hearing aids includes a matched set of transducers, each coupled to inputs of individual impedance-buffer amplifiers 3a which utilize ultra-high impedance input biasing circuitry for optimal electronic noise performance. The input biasing circuitry frequently takes the form of a pair of parallel diodes connected with opposite polarity to a DC voltage reference. The input biasing circuitry typically has an input impedance of about 10⁴ Giga-ohms or 10 Tera-ohms. The biasing circuitry is then coupled to the inputs of each impedance-buffer amplifier.

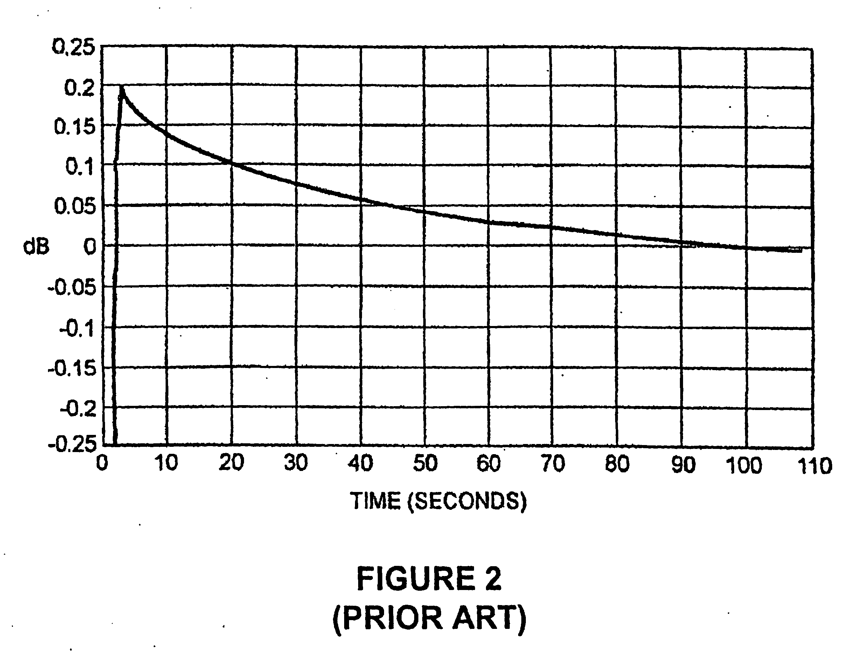

One noticeable performance limitation exists among state-of-the-art, low-noise, miniature electret microphones, especially when utilized in directional hearing aids as part of a set of two or more matched transducers. Namely, upon initial power-up and often after loud acoustic transients, the microphone's sensitivity exhibits a slow exponential settling characteristic which often takes several minutes to completely subside. As shown in Fig. 2, this slow microphone sensitivity settling characteristic typically has a time constant on the order of about 0.2 dB per minute. Using such ultra-high-impedance input-biasing circuitry has the advantage of obtaining optimum noise performance from the microphone, but results in the drawback of this slow settling characteristic in microphone sensitivity in response to transient voltage spikes at the microphone output, for example, as a result of initial power on or an acoustic impulse.

Because differences in sensitivity among the microphones limit the spatial accuracy and shape of the directional response of the hearing aid, consistent and predictable microphone sensitivity characteristics from each unit in a matched set of transducers are highly desirable for high performance directional hearing aids. Small differences in microphone sensitivity, on the order of 0.5 dB, are enough to cause appreciable degradation in the response of a directional hearing aid that utilizes only two microphones. Higher directionality hearing aids, which utilize multiple matched microphones, i.e., three or more, require even tighter sensitivity matching. Thus, it is apparent that a sensitivity settling time constant on the order of about 0-2 dB per minute might pose noticeable and perhaps significant performance limitations for directional hearing aids.

WO-A-83/02862 describes an arrangement for addressing transients that might adversely affect the performance of a listening device by attempting to control a damper coupled to the output of its microphone to reduce or eliminate these potentially damaging transients.

### BRIEF DESCRIPTION OF THE DRAWINGS

Fig. 1 is a simplified and representative block diagram of a prior art hearing aid;
Fig. 2 is a graph depicting the microphone sensitivity settling characteristic of a typical prior art miniature electret microphone coupled to a buffer amplifier;
Fig. 3 is a simplified and representative block diagram of a hearing aid in accordance with the current invention;
Fig. 4 is a schematic drawing of one embodiment of the reset circuit of the present invention; and
Fig. 5 is a schematic drawing of an alternative embodiment of the reset circuit of the present invention also showing the buffer amplifier.

### DETAILED DESCRIPTION

While the present invention is susceptible to various modifications and alternative forms, certain embodiments are shown by way of example in the drawings and these embodiments will be described in detail herein. It should be understood, however, that this disclosure is not intended to limit the invention to the particular forms described, but to the contrary, the invention is intended to cover all modifications, alternatives, and equivalents falling within the scope of the invention defined by the appended claims.

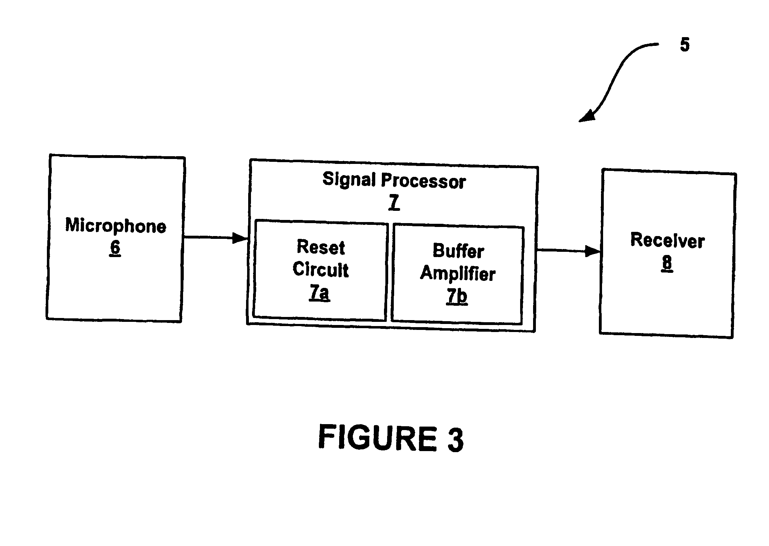

Referring to Fig. 3, an auxiliary circuit, or reset circuit 7a is added to the signal processor 7. The reset circuit 7a is utilized to perform a reset for an appropriate length of time at the input of the buffer amplifier 7b, used in, for example, a hearing aid. The reset circuit 7a operates without significantly degrading the microphone noise performance or other normal operating characteristics to achieve a definite overall product performance improvement. Such a performance benefit is obtained by the use of the reset circuit 7a to temporarily, but substantially, reduce the impedance at the input of the buffer amplifier 7b by enabling a shunt transistor across the input. The reset circuit 7a may be activated by a power-on-reset ("POR"), a voltage excursion at the output of the buffer amplifier, or a manual reset that utilizes a dedicated control pin. The reset circuit effectively reduces the settling characteristic of the microphone sensitivity after power-up from a very slow time constant, typically requiring minutes, to a very fast time constant, i.e. fractions of a second. A microphone sensitivity stabilization improvement of this order can markedly improve the signal-to-noise ratio (S/N) performance of the hearing aid 5 in general and even more dramatically for directional hearing aids. As a result, users of such hearing aids benefit in terms of usability and performance.

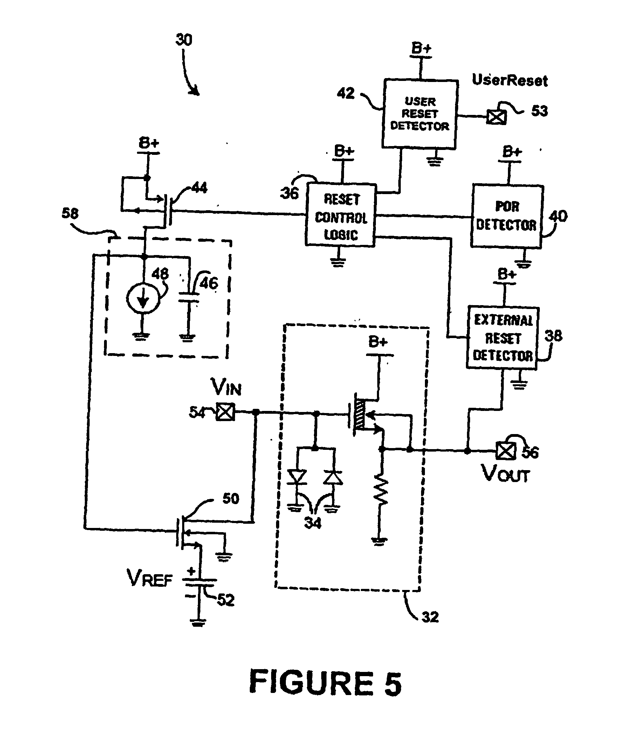

It should be noted that the above sensitivity settling improvement can be further enhanced by enabling a hearing-aid-system controller with the capability of triggering a "reset" of the buffer amplifier 7b input at times other than immediately following powering up of the microphone. For example, the same slow settling characteristics in microphone sensitivity frequently result immediately after the occurrence of loud acoustic transients, e.g., sudden, yet brief, loud noises. When a hearing aid controller is capable of triggering a brief buffer amplifier input reset immediately after such loud acoustic transient events, a benefit in overall performance is observed. The controller can be configured to detect that acoustic or system events might have caused an undesirable sensitivity mismatch among the various microphones mounted in a directional hearing aid shell. Another configuration of the reset circuit 7a may include a capability to manually activate the reset function, for example, by manufacturing or test personnel and is discussed in more detail with respect to FIG. 5.

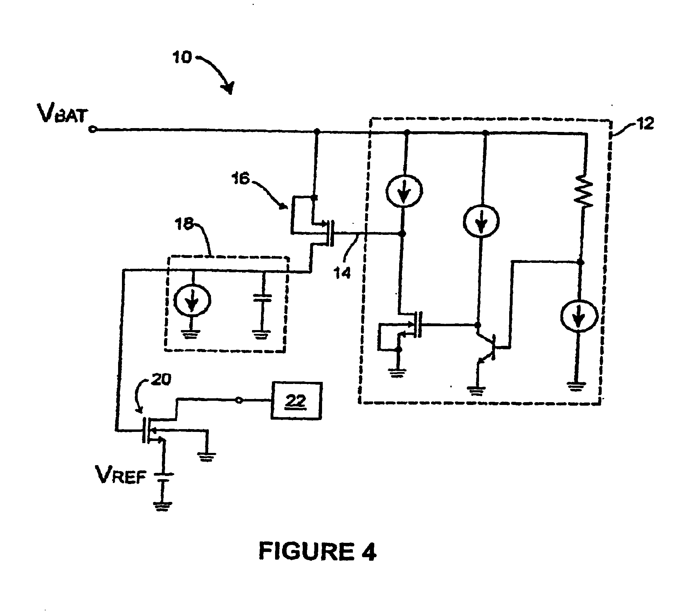

FIG. 4 is one embodiment of a reset circuit 7a that is useful for improving microphone sensitivity settling. The illustrated POR circuit 10 can be utilized for triggering the above-described temporary impedance reduction, or reset, at the input 22 of a buffer amplifier 7b of the hearing aid 5 in FIG. 3. Note that the input 22 of the buffer amplifier7b is essentially the same as that indicated by input 54 in FIG. 5. The POR circuit 10 is utilized to help ensure that the microphone 6, and hence the hearing aid 5, both "power up" into known and predictable initial operating states.

One embodiment of the POR circuit 10 in FIG. 4 includes a detector 12 to determine whether a power supply, V_{BAT}, is at or above a predetermined threshold, e.g., 0.7 volts, whereby the system would be considered to be in a legitimate power-up state. The detector 12 includes an output 14 operably connected to the gate of a switch 16 that is utilized to reset a ramp down generator 18, for example, a 200 picoampere (pA) current sink and a 20 picofarad (pF) capacitor, whenever the power supply is below the predetermined threshold. The output of the ramp down generator 18 creates a substantially predictable amount of POR delay, so that a reset or shunt device 20 is turned "off' after a substantially fixed time delay, typically about 70 milliseconds (mS), after the predetermined power supply threshold has been exceeded. Another advantage of using the output of the ramp down generator 18 to directly control the gate of the buffer amplifier input reset device 20 and turn it "off' is that the slow ramp down signal avoids the problem of charge injection directly into the buffer input represented by reference 22, which if switched "off' quickly might inject charge into the buffer input 22 which can itself introduce a long microphone sensitivity settling characteristic.

Any number of known semiconductor technologies are suitable for implementing the reset circuitry to place the buffer amplifier input 22 into a consistent and predictable operating state or condition that in turn provides a stable microphone sensitivity characteristic. For example, the circuitry can be implemented in bipolar technology or in a metal-oxide semiconductor (MOS). In a MOS device, both positive-channel (PMOS) and negative-channel (NMOS) transistors can be fabricated. In operation, the "reset" of an buffer amplifier input 22 is accomplished, in one exemplary embodiment, via a small N-channel Enhancement metal-oxide semiconductor field effect transistor (MOSFET) switch, such as the buffer amplifier input reset device 20. The "on" or "off' state of the buffer amplifier input reset device 20 is controlled by a gate voltage provided by the ramp down generator 18 signal output. The drain terminal of the buffer amplifier input reset device 20 is directly connected to the buffer amplifier input 22. When implemented in NMOS the reset device 20 has a very high on-resistance, or impedance, on the order of 10 Tera-ohms when the device's 20 gate-to-source voltage, V_{GS}, is zero or negative.

The on-resistance of the reset device 20 becomes quite low when the V_{GS} voltage of the reset device 20 is near or above its threshold or turn-on voltage, e.g., approximately 0.5 volts. The on-resistance is particularly low, in the kilo-ohm range, when compared to the impedance of the input circuit 22, such as the tera-ohm impedance of the cross-coupled diodes 34 of Fig. 3. When the buffer amplifier input reset device 20 is "on," it will substantially reduce the input impedance of the buffer circuit 22 to a value on the order of kilo-ohms and cause the buffer amplifier input 22 to bias quickly into a well-defined and predictable operating condition.

The biasing provided by V_{REF}, in tandem with a long channel length NMOS device (typically about 50 micrometers µm), but may be longer or shorter depending upon the "off' state leakage properties of the NMOS device) for the buffer amplifier input reset device 20 both aid in keeping "off' state impedance of the reset device 20 very high under worst case manufacturing and operating conditions. In an embodiment where the nominal threshold voltage (V_{T}) is approximately 0.5 volts, for example, when using Enhanced NMOS, a V_{REF} of 100mV is suggested. Such a biasing technique ensures robust, consistent, and optimal buffer amplifier noise performance, which is crucial for miniature hearing aid microphones.

As illustrated in Fig. 5, other signals relating to one or more "reset" control events can also be utilized to drive the gate of a ramp generator reset switch 44. For example, additional "reset" control signals for the buffer amplifier can be multiplexed into the miniature microphone via the buffer output terminal, Vout 56. The reset control logic 36 can receive signals from a number of sources, for example, the external reset detector 38, the POR detector 40 and a user reset detector 42. The external reset detector 38 may be responsive to predetermined voltage level changes but other mechanisms can be used.

This combinatory reset control logic 36 can be implemented via digital logic circuitry on the same IC as the buffer amplifier 32, and allows for a general purpose "reset" signal whenever the hearing aid system requires the input 54 of the microphone's buffer amplifier 32 to be temporarily placed into a low impedance state. Thus, the reset control logic 36 can implement a highly sophisticated reset control mechanism for a hearing aid system, as described below. The use of the reset control logic 36 as described is used to improve directionality and S/N performance for a hearing impaired end user as well as improve manufacturing cycle times.

The buffer amplifier 32 achieves a high input impedance primarily from cross coupled or anti-parallel diodes 34. The POR detector 40 operates as discussed above, i.e. in the same fashion as that described for the circuitry 10 in Fig. 2. The external reset detector 38 operates to monitor the output V_{OUT} 56 of the buffer amplifier 32. When the electret microphone 6 receives a significant acoustic transient, the electret microphone transmits a voltage spike to the buffer amplifier circuit input, V_{IN} 54. The external reset detector 38 monitors the output V_{OUT} 56 for the corresponding output voltage excursions, and when voltage excursions corresponding to an acoustic transient are observed the detector generates a digital control signal that is sent to the reset control logic 36. The reset control logic 36 will then trigger a reset. As a result, the input V_{IN} 54 will settle back to the desired operating state in a relatively short, substantially fixed time rather than an unknown period of time up to several minutes. What constitutes a significant acoustic transient to trigger a reset is empirically determined. For example, in a laboratory environment, the sound pressure level required to cause a given decibel level sensitivity offset, such as the 0.2 dB offset of Fig. 1 can be measured. The corresponding output voltage excursion can be programmed into the external reset detector, setting the level of the trigger.

The user reset detector 42 is provided primarily for use by hearing aid system controllers and manufacturing or test personnel. The user reset detector 42 allows a microphone reset to be generated at any time via a dedicated control pin 53.

When the reset control logic 36 triggers switch 44, the voltage at the gate of the reset or shunt transistor 50 is pulled high, causing it to turn "on," thus lowering the input impedance of the buffer amplifier input node 54. Compared to the input buffer impedance of many tera-ohms (10¹²) under normal operation (i.e., when shunt transistor 50 is "off'), the reduced input impedance while device 50 is "on" during a "reset" state is of the order or kilo-ohms (10³), a difference of about nine orders of magnitude. The voltage source V_{REF} 52 helps to ensure that transistor 50 remains off and in a very high impedance state should there be any slight fluctuations at its gate due to leakage or signal coupling due to elevated temperature, or due to circuit component tolerance variations. As the ramp generator 58 gradually pulls the gate of shunt transistor 50 back near ground, switch 50 is gradually turned off.

The gradual turn off of switch 50 is advantageous to maintaining stable microphone sensitivity performance, for two reasons:
A) t he gradual turn off minimizes any charge injection onto the buffer input node 54, which would upset the bias condition of the buffer circuit 32 and subsequently cause the microphone sensitivity to become unsettled for a significant duration of time, and
B) the gradual turn off ensures that no residual charge is stored on the electret transducer itself (e.g. when the transducer is responding to an acoustic transient or while the microphone is coming out of its reset state), that can also introduce an operating point offset at the buffer circuit input 54 and subsequently cause the microphone sensitivity to become unsettled for a significant duration of time.

The components of the reset circuits 10 and 30 are known and available. The Enhancement PMOS and Enhancement NMOS device construction is well known and documented in semiconductor textbooks and by semiconductor fabrication companies such as National Semiconductor. While typically such a circuit may be fabricated as a custom or semi-custom integrated circuit, a discrete implementation can be constructed from components available from parts distributors such as Arrow Electronics or Hamilton Avnet.

In addition to the inherent performance benefits for actual hearing aids utilizing such microphones as described above, there is also a benefit purely from a product manufacturing point of view. This benefit is realized primarily during product test, both for the hearing aid manufacturer and the microphone transducer manufacturer. A microphone using the reset circuit described settles within fractions of a second rather than minutes and can vastly increase product throughput at each product test stage. This can result in significantly reducing the overall manufacturing cost of both the transducer and the hearing aid system.

Additional product test benefits may include improved consistency in the calibration and/or the characterization of the microphone sensitivity and the directionality performance of hearing aids. Such benefits may result in improved overall transducer quality, perhaps even resulting in a reduction of returned hearing aid products and/or transducer components. Both of these testing benefits would facilitate a reduction in overall hearing aid product cost, an improvement in business profitability, as well as the possibility of an increased improvement in general public's subjective opinion of the performance of hearing aids, and directional hearing aids in particular.

The use of the terms "a" and "an" and "the" and similar referents in the context of describing the invention (especially in the context of the following claims) are to be construed to cover both the singular and the plural, unless otherwise indicated herein or clearly contradicted by context. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventor for carrying out the invention. It should be understood that the illustrated embodiments are exemplary only, and should not be taken as limiting the scope of the invention.

## Claims

1. A reset circuit (7a) for use with a buffer circuit (7b) comprising:
one or more detectors (12, 38, 40, 42), each having a first input, a first output and a predetermined threshold, the first output of at least one of the
detectors (12, 38, 40, 42) configured to generate an output signal from the first input signal that is indicative of a power-up state, a voltage excursion at the output of the buffer circuit or a manual reset condition:
a ramp generator (18, 58) coupled to one or more of the detectors (12, 38, 40, 42), the ramp generator (18, 58) having a second output, the second output being based upon the first output of one or more of the detectors (12, 38, 40, 42); and a shunt device (20, 50) coupled to the ramp generator (18, 58) to receive the second output, the shunt device being connected to the buffer circuit (7b), and being configured to be controlled by the second output to temporarily reduce an input impedance of the buffer circuit (7b).

2. The reset circuit of claim 1 wherein the shunt device (20, 50) temporarily reduces the input impedance of the buffer circuit (7b) thereby altering a settling characteristic of the buffer circuit (7b)

3. The reset circuit of claim 1 wherein the detectors (12, 38, 40, 42) are threshold detectors.

4. The reset circuit of claim 1 wherein a signal to the input of the one or more detectors comprises one of a power supply level, a transient voltage, and a reset signal.

5. The reset circuit of claim 1 further comprising a source terminal of the shunt device (20, 50) coupled to a voltage reference, the voltage reference to ensure a high impedance state of the shunt device (20, 50) when the shunt device (20, 50) is off.

6. The reset circuit of claim 1 further comprising a switch (44), the switch (44) comprising an Enhancement P-channel metal-oxide semiconductor (PMOS) transistor, a gate of the switch (44) coupled to the first output, a source terminal of the switch (44) coupled to a first power source and a drain terminal of the switch (44) coupled to the second output.

7. The reset circuit of claim 1, wherein the ramp generator (18, 58) output limits charge injection from the shunt device (20, 50) to the input of the buffer circuit (7b).

8. The reset circuit of claim 1 wherein the ramp generator (18, 58) comprises a current sink and a capacitor.

9. A method for improving a settling time of a microphone buffer circuit (7b) comprising:
sensing a condition indicative of a power up state,
a voltage excursion at an output of the microphone buffer circuit (7b) or a manual reset indication; and
resetting at an input of the microphone buffer circuit (7b) with a ramp generator to temporarily reduce an input impedance of the microphone buffer circuit (7b) in response to the condition, thereby improving the settling time of the microphone buffer circuit (7b).

10. The method of claim 9 wherein sensing the condition further comprises:
sensing one of a voltage source, a transient voltage, and a control signal.

11. The method of claim 9 wherein sensing the condition further comprises detecting whether an input signal of the microphone buffer circuit (7b) is at or about a threshold.

12. The method of claim 9 further comprising generating an output in response to the condition, the output for setting a length of time that the input impedance for the buffer amplifier is reduced.

13. The method of claim 9 further comprising:
activating a variable impedance device (20) for reducing temporarily the input impedance of the microphone buffer circuit (7b).

14. The method of claim 13 further comprising:
applying a bias voltage to the variable impedance device (20) to improve a high impedance state of the variable impedance device.

## Patentansprüche

1. Zurücksetzschaltung (7a) für eine Pufferschaltung (7b), umfassend einen oder mehrere Detektoren (12, 38, 40, 42), von denen jeder einen ersten Eingang, einen ersten Ausgang und eine vorbestimmte Schwelle hat, wobei der erste Ausgang der Detektoren (12, 38, 40, 42) so gebaut ist, daß ein Ausgangssignal von dem ersten Eingangssignal erzeugt wird, welches einen Aufladungszustand, einen Spannungsverlauf am Ausgang der Pufferschaltung oder eine manuelle Rücksetzbedingung anzeigt: mit einem Auflauf-Generator (18, 58), der mit einem oder mehreren Detektoren (12, 38, 40, 42) gekoppelt ist und einen zweiten Ausgang hat, der sich auf den ersten Ausgang oder einen oder mehrere Detektoren (12, 38, 40, 42) stützt; und mit einer Nebenschluß-Vorrichtung (20, 50), die mit dem Auflauf-Generator (18, 58) zum Empfang des zweiten Ausgangs gekoppelt ist, und wobei die Nebenschluß-Vorrichtung mit der Pufferschaltung (7b) verbunden und so gebaut ist, daß sie durch den zweiten Ausgang gesteuert wird, um einen Eingangswiderstand der Pufferschaltung (7b) zeitweilig zu verringern.

2. Zurücksetzschaltung nach Anspruch 1, **dadurch gekennzeichnet, daß** die Nebenschluß-Vorrichtung (20, 50) den Eingangs-Widerstand der Pufferschaltung (7b) zeitweilig verringert, um dadurch eine Stabilisierungscharakteristik der Pufferschaltung (7b) zu ändern.

3. Zurücksetzschaltung nach Anspruch 1, **dadurch gekennzeichnet, daß** die Detektoren (12, 38, 40, 42) Schwellendetektoren sind.

4. Zurücksetzschaltung nach Anspruch 1, **dadurch gekennzeichnet, daß** ein Signal für den Eingang des einen oder mehrerer Detektoren eine Spannungszufuhrhöhe, eine Übergangsspannung oder ein Rücksetz-Signal beinhaltet.

5. Zurücksetzschaltung nach Anspruch 1, ferner **gekennzeichnet durch** einen Quellenanschluß der Nebenschluß-Vorrichtung (20, 50), gekoppelt an eine Bezugsspannung, die dazu dient, einen hohen Widerstandswert der Nebenschluß-Vorrichtung (20, 50) sicherzustellen, wenn die Nebenschluß-Vorrichtung (20, 50) abgeschaltet ist.

6. Zurücksetzschaltung nach Anspruch 1, ferner **gekennzeichnet durch** einen Schalter (44), der einen Halbleiter-Transistor mit verstärkendem P-Kanal-Metalloxid (PMOS), ein Tor für den Schalter (44), das mit dem ersten Ausgang gekoppelt ist, einen Quellenanschluß des Schalters (44), der mit der ersten Stromquelle gekoppelt ist, und einen Abflußanschluß des Schalters (44), der mit dem zweiten Ausgang gekoppelt ist.

7. Zurücksetzschaltung nach Anspruch 1, **dadurch gekennzeichnet, daß** der Ausgang des Auflauf-Generators (18, 58) die Aufladung von der Nebenschluß-Vorrichtung (20, 50) zum Eingang der Pufferschaltung (7b) begrenzt.

8. Zurücksetzschaltung nach Anspruch 1, **dadurch gekennzeichnet, daß** der Auflauf-Generator (18, 58) eine Stromsenke und einen Kondensator aufweist.

9. Verfahren zur Verbesserung einer Stabilisierungszeit einer Mikrofon-Pufferschaltung (7b), umfassend: Ermittlung einer Bedingung, die für einen Leistungszunahme-Zustand kennzeichnend ist sowie für einen Spannungsverlauf an einem Ausgang der Mikrofon-Pufferschaltung (7b) oder einer manuellen Rücksetzanzeige; und Zurücksetzen eines Eingangs der Mikrofon-Pufferschaltung (7b) mit einem Auflauf-Generator zur zeitweiligen Verringerung eines Eingangs-Widerstandes der Mikrofon-Pufferschaltung (7b) als Folge der Bedingung, um dadurch die Stabilisierungszeit der Mikrofon-Pufferschaltung (7b) zu verbessern.

10. Verfahren nach Anspruch 9, **dadurch gekennzeichnet, daß** die Ermittlung des Zustandes des weiteren das Feststellen einer Spannungsquelle, einer Übergangsspannung und eines Steuersignals umfaßt.

11. Verfahren nach Anspruch 9, **dadurch gekennzeichnet, daß** die Ermittlung des Zustandes ferner umfaßt festzustellen, ob ein Eingangssignal der Mikrofon-Pufferschaltung (7b) an einer oder im Bereich einer Schwelle liegt.

12. Verfahren nach Anspruch 9, ferner **gekennzeichnet durch** Erzeugen eines Ausgangs aufgrund der Bedingung, wobei der Ausgang zur Einstellung einer Zeitlänge so geartet ist, daß der Eingangs-Widerstand für den Pufferverstärker verringert wird.

13. Verfahren nach Anspruch 9, ferner **gekennzeichnet durch** Aktivieren einer variablen Widerstands-Vorrichtung (20) zur zeitweiligen Verringerung des Eingangs-Widerstandes der Mikrofon-Pufferschaltung (7b).

14. Verfahren nach Anspruch 13, ferner **gekennzeichnet durch** Beaufschlagen der variablen Widerstands-Vorrichtung (20) mit einer Vorspannung, um dadurch einen Hochwiderstands-Zustand der variablen Widerstands-Vorrichtung zu verbessern.

## Revendications

1. Circuit de remise à zéro (7a) destiné à être utilisé avec un circuit tampon (7b) comprenant :
- un ou plusieurs détecteurs (12, 38, 40, 42), ayant chacun une première entrée, une première sortie et un seuil prédéterminé, la première sortie d'au moins l'un des détecteurs (12, 38, 40, 42) étant configurée pour générer, à partir du premier signal d'entrée, un signal de sortie qui est indicatif d'un état sous tension, d'une excursion de tension à la sortie du circuit tampon ou d'une condition de remise à zéro manuelle ;
- un générateur de rampe (18, 58) couplé à un ou plusieurs des détecteurs (12, 38, 40, 42), le générateur de rampe (18, 58) ayant une seconde sortie, la seconde sortie étant basée sur la première sortie d'un ou plusieurs des détecteurs (12, 38, 40, 42) ; et
- un dispositif de shuntage (20, 50) couplé au générateur de rampe (18, 58) pour recevoir la seconde sortie, le dispositif de shuntage étant connecté au circuit tampon (7b), et étant configuré pour être commandé par la seconde sortie pour réduire temporairement une impédance d'entrée du circuit tampon (7b).

2. Circuit de remise à zéro selon la revendication 1, dans lequel le dispositif de shuntage (20, 50) réduit temporairement l'impédance d'entrée du circuit tampon (7b) de façon à modifier ainsi une caractéristique d'établissement du circuit tampon (7b).

3. Circuit de remise à zéro selon la revendication 1, dans lequel les détecteurs (12, 38, 40, 42) sont des détecteurs à seuil.

4. Circuit de remise à zéro selon la revendication 1, dans lequel un signal sur l'entrée du ou des détecteurs comprend l'un d'un niveau d'alimentation électrique, d'une tension transitoire et d'un signal de remise à zéro.

5. Circuit de remise à zéro selon la revendication 1, comprenant en outre une borne de source du dispositif de shuntage (20, 50) couplée à une tension de référence, la tension de référence assurant un état d'impédance élevée du dispositif de shuntage (20, 50) lorsque le dispositif de shuntage (20, 50) est hors circuit.

6. Circuit de remise à zéro selon la revendication 1, comprenant en outre un commutateur (44), le commutateur (44) comprenant un transistor à métal-oxyde-semiconducteur à canal P (PMOS) à enrichissement, une grille du commutateur (44) étant couplée à la première sortie, une borne de source du commutateur (44) étant couplée à une première source d'alimentation et une borne de drain du commutateur (44) étant couplée à la seconde sortie.

7. Circuit de remise à zéro selon la revendication 1, dans lequel la sortie du générateur de rampe (18, 58) limite l'injection de charge du dispositif de shuntage (20, 50) à l'entrée du circuit tampon (7b).

8. Circuit de remise à zéro selon la revendication 1, dans lequel le générateur de rampe (18, 58) comprend un collecteur de courant et un condensateur.

9. Procédé d'amélioration d'un temps d'établissement d'un circuit tampon de microphone (7b) comprenant :
- la détection d'une condition indicative d'un état sous tension, d'une excursion de tension à une sortie du circuit tampon de microphone (7b) ou d'une indication de remise à zéro manuelle ; et
- la remise à zéro à une entrée du circuit tampon de microphone (7b) avec un générateur de rampe pour réduire temporairement une impédance d'entrée du circuit tampon de microphone (7b) en réponse à la condition, de façon à améliorer ainsi le temps d'établissement du circuit tampon de microphone (7b).

10. Procédé selon la revendication 9, dans lequel la détection de la condition comprend en outre la détection de l'un d'une source de tension, d'une tension transitoire et d'un signal de commande.

11. Procédé selon la revendication 9, dans lequel la détection de la condition comprend en outre :
- la détection du fait qu'un signal d'entrée du circuit tampon de microphone (7b) est à ou environ à un seuil.

12. Procédé selon la revendication 9, comprenant en outre la génération d'une sortie en réponse à la condition, la sortie étant destinée à établir une durée de temps de laquelle l'impédance d'entrée de l'amplificateur tampon est réduite.

13. Procédé selon la revendication 9, comprenant en outre :
- l'activation d'un dispositif à impédance variable (20) destiné à réduire temporairement l'impédance d'entrée du circuit tampon de microphone (7b).

14. Procédé selon la revendication 13, comprenant en outre :
- l'application d'une tension de polarisation au dispositif à impédance variable (20) pour améliorer un état d'impédance élevée du dispositif à impédance variable.
